# EUROPEAN PATENT SPECIFICATION

(11) **EP 3 716 326 B1**
(45) Date of publication and mention of the grant of the patent: **21.10.2026**
(21) Application number: 19164827.8
(22) Date of filing: 25.03.2019
(51) Int. Cl.: H05K 1/185, H05K 3/46, H05K 1/02, H10W 70/685, H10W 70/60

(54) **ELECTRICALLY POWER ASSEMBLY WITH THICK ELECTRICALLY CONDUCTIVE LAYERS**
ELEKTRISCHE LEISTUNGSANORDNUNG MIT DICKEN ELEKTRISCH LEITFÄHIGEN SCHICHTEN
ENSEMBLE D'ALIMENTATION ÉLECTRIQUE COMPORTANT DES COUCHES ÉLECTRIQUEMENT CONDUCTRICES ÉPAISSES

(43) Date of publication of application: 30.09.2020
(73) Proprietor: Mitsubishi Electric R&D Centre Europe B.V., 1119 NS Schiphol Rijk Amsterdam (NL); Mitsubishi Electric Corporation, Tokyo 100-8310 (JP)
(72) Inventor: MRAD, Roberto, 35708 RENNES Cédex 7 (FR); MOLLOV, Stefan, 35708 RENNES Cédex 7 (FR)
(74) Representative: Plasseraud IP

(56) References cited:
- EP-A1- 3 148 300
- EP-A2- 2 854 168
- EP-A2- 3 252 812
- US-A1- 2002 108 776

## Description

### FIELD OF THE INVENTION

The invention relates to an electrically power assembly comprising at least one power device embedded in a multilayer base structure and at least one external thick electrically conductive layer providing better current and thermal transfer of the power device. The invention also relates to a manufacturing method of the power assembly.

### BACKGROUND OF THE INVENTION

Power dies, such as diodes or various types of power transistors (MOSFET, JFET, IGBT, HEMT) are elementary components of power modules which are used for the control and conversion of electric power, for instance in many different fields such as in the automotive, aeronautic, railway industries.

Currently the most common way to connect a power die to other components, for instance in a power module, is by using a substrate such as a Direct Bonded Copper (DBC) Substrate, which comprises a ceramic plate with at least one side covered with a copper layer. Power dies are soldered or sintered on the DBC substrate on one side, and connected on the other side of the power die by wire bonds or ribbons that are ultrasonically welded on the die metallization.

The constant increase in the switching frequency and density of power leads a need for thermal enhancement, volume reduction and reliability increase of the power modules.

In this perspective, the traditional power connection by wire bonding of a power die on a substrate has a number limitations and drawbacks, among which the high parasitic level and low reliability due to wire bonds.

A new packaging technology is emerging which consists of manufacturing pre-packed power cells comprising at least one power die embedded in a Printed Circuit Board (PCB) laminate. The power dies are then connected to electrically conductive layers through plated vias.

This new packaging solution allows easier connection of the power dies on a substrate. In addition, the connection by plated vias increases the reliability and reduces the parasitic elements of the interconnection.

A conventional method for manufacturing a power device packaging comprises the following steps:
- forming a cavity of the size of the power die in an electrically insulating core,
- inserting a power device in the cavity,
- positioning the electrically insulating layer comprising the power device between two additional electrically insulating layer, to obtain a stack of electrically insulating layers,
- positioning the stack of electrically insulating layers between two external electrically conductive layers,
- laminating the stack of electrically insulating layers and the external electrically conductive layers,
- drilling plural via holes by laser,
- plating the vias hole in order to connect the contact pads of the external electrically conductive layers to the respective electrical contact of the power die,
- increasing the thickness of the external electrically conductive layers by plating to required thickness according to the needs of the power electronic applications in order to increase power and thermal transmission.
- patterning the surface of the external electrically layers in order to form a desired layout.

However, in such power device packaging structure, in order to obtain higher thermal and electrical performances of the power devices, it is preferable to have vias filled with copper and a thick copper layer on the package structure. Therefore, the step of plating the vias is longer in order to reach the required thickness for the two electrically conductive layers. Such method makes the process costly.

The other solution is to obtain in first a thick external electrically layers before performing the step of drilling the vias. However, there is another problem which resides in the drilling laser capabilities which are limited in thick electrically conductive layers.

EP 2 854 168 A2 discloses an embedded semiconductor package structure comprising a semiconductor device embedded in dielectric layers, with conductive vias and interconnects formed on both sides of the semiconductor device.

EP14184831.7 relates to a package structure including a dielectric layer, at least one semiconductor device attached to the dielectric layer, one or more dielectric sheets applied to the dielectric layer and about the semiconductor device(s) to embed the semiconductor device(s) therein, and a plurality of vias formed to the semiconductor device(s) that are formed in at least one of the dielectric layer and the one or more dielectric sheets.

US09/880037 relates to a multilayer printed circuit board is provided which includes a base member having a surface provided with a base wiring pattern, an inner buildup layer laminated on the base member and having a surface formed with an inner buildup wiring pattern, and an outer buildup layer laminated on the surface of the inner buildup layer and having a surface formed with an outer buildup wiring pattern. The wiring patterns are electrically connected to each other through vias. The inner buildup layer is formed of a resin material which is not reinforced by glass fibers, whereas the outer buildup layer is formed of a resin material reinforced by glass fibers.

Therefore, there is a need of providing an improved package structure in order to eliminate the above drawbacks.

### DESCRIPTION OF THE INVENTION

The invention is set out in the claims. An electrical power assembly according to the invention is defined in claims 1 to 7. The related method for manufacturing the electrical power assembly according to the invention is defined in claims 8 to 15.

The power assembly according to the invention provides a good thermal dissipation and a high power transmission thanks to the thick external electrically conductive layers positioned on each side of the multilayer base structure.

In addition, the use of pre-drilled holes formed in the thick electrically conductive layers before lamination permits to drill the thick electrically conductive layers by mechanical process or any appropriate process and overcome the laser drilling limitation.

### DESCRIPTION OF THE DRAWINGS

Other features and advantages of the invention will be apparent from the following detailed description given by way of non-limiting example, with reference to the accompanying drawings, in which:
- Figures 1A to 1G are schematic cross-sectional views of an electrical power assembly according to a first embodiment of the invention,
- Figure 2 is a schematic cross-sectional view of an electrical power assembly according to a second embodiment of the invention,
- Figures 3A to 3D are schematic cross-sectional views of an electrical power assembly according to a third embodiment of the invention,
- Figure 4 is a schematic cross-sectional view of an electrical power assembly according to a fourth embodiment of the invention,
- Figures 5A and 5B schematically represent the main steps of a manufacturing method of an electrically power assembly according to an embodiment of the invention.

### DETAILED DESCRIPTION OF AT LEAST AN EMBODIMENT OF THE INVENTION

In this disclosure, the term "electrical power assembly" refers to a package structure comprising at least one power device embedded in a multilayer structure like a PCB laminate in order to form a power module.

In this disclosure, the term "insulating layer" or "insulating core" refers to a layer or core made of thermally conductive and electrically insulating material.

In this disclosure, the term "conductive layer" refers to a layer made of electrically and thermally conductive material.

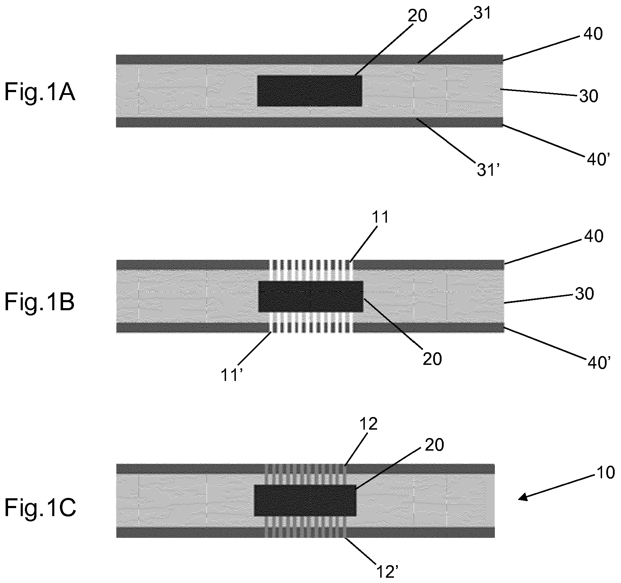

With reference to figure 1A to figure 1G, an electrical power assembly 100 according to a first embodiment of the invention will now described.

Referring to figures 1A to 1C, the power assembly 100 comprises an insulating core 30, in which is embedded a power device 20. The power device may be a diode or a MOSFET, a JFET or IGBT, HEMT. In some embodiments, the power device is made from a wide bandgap semiconductor, i.e. a semiconductor having a bandgap in the range of 2-4 eV. For instance, the power device may be made in Silicon Carbide SiC or in Gallium Nitride GaN.

The power device has at least two electrical contacts (not shown) which are metallic pads such as aluminum, gold, copper, silver etc.

For instance, the power device is a diode and has two opposite electrical contacts. In another example, the power device is a transistor and has three electrical contacts comprising a gate, a source and a drain or a gate, an emitter and a collector, according to the type of transistor. The power device could also have a number of electrical contacts greater than three.

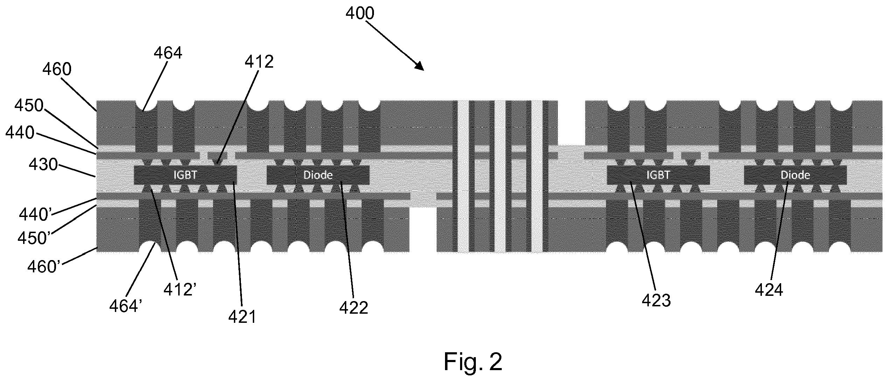

In addition, the power assembly 100 may comprise at least one additional power device as shown in figure 2 and/or an electronic passive component such as a resistor, a capacitor, or other, connected to the first power device.

As non-limiting examples, the insulating core 30 is made of resin or any other appropriate insulating material with high thermal conductivity to provide better heat dissipation. The insulating core may be made of FR-4 glass epoxy, polyimide, or in ceramic such as HTCC (High-Temperature Co-Fired Ceramic) or LTCC (Low Temperature Co-fired Ceramic).

In addition, the electrical power assembly 100 further comprises a top internal conductive layer 40 and a bottom internal conductive layer 40'. The top internal conductive layer 40 is disposed on a top surface 31 of the insulating core 30. The bottom internal conductive layer 40' is disposed on a bottom surface 31' of the insulating core 30. The material of these conductive layers is a metal, preferably copper.

Moreover, a set of top conductive vias 12 and a set of bottom vias 12' are formed in the insulating core 30 and in the top and bottom internal conductive layers 40, 40'. The contact pads of the top internal conductive layer 40 are connected to the electrical contacts on a top surface of the power device 20 by the set of top vias 12. The contact pads of the bottom internal conductive layer 40' are connected to the electrical contacts on a bottom surface of the power device by the set of bottom vias 12'. The power device 20 is therefore connected to the top internal conductive layer 40 and the bottom internal conductive layer 40' through the electrical pads, the set of top vias 12 and the set of bottom vias 12'.

The method of forming the top vias 12 and the bottom vias 12' are well known to those skilled in the art. After laminating the stack up comprising the insulating core 30 and the two internal conductive layers 40, 40' in order to obtain a solid assembly, a set of bottom vias holes 11 and a set of bottom vias holes 11' are formed by laser drilling process at each side of the stack allowing the exposition of the electrical contacts of the power device 20. Then, the vias holes 11, 11' are filled with a conductive material such as copper by an electroplating process or electroless or both in order to form conductive vias 12, 12'.

Moreover, an etching step is applied on the surface of the top conductive layer 40 and the surface of the bottom conductive layer 40' in order to obtain respectively top conductive pattern and bottom conductive pattern. Therefore, the top conductive pattern and the bottom conductive pattern are served as the contact pads of the top internal conductive layer 40 and the bottom internal conductive layer 40'.

According to a non-limiting embodiment, the internal conductive layers 40, 40' may have a thickness of about 20-50 µm.

The number of the vias is chosen according to the power transmission. These numbers depend also on the drilling technique, laser or mechanical. For instance, the density of vias connecting the electrical contact of the power device with the internal conductive layers may be at least 4 vias/mm², for instance 15 vias/mm², for instance with a ratio vias hole depth to drill diameter of 0.8. In another example wherein the power device is a MOSFET or IGBT, only one via connects the gate pad to the internal conductive layer.

The package structure as described above forms an example of multilayer base structure 10 comprising the insulating core 30 and two thin internal conductive layers 40, 40' covering opposite surfaces of the insulating core 30, the insulating core 30 embedded at least one power device 20.

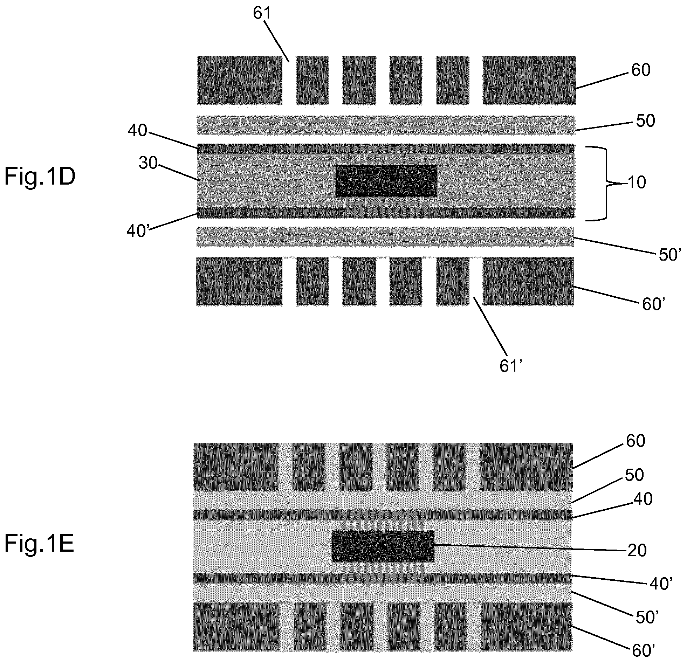

Referring to figures 1D to 1G, the power assembly 100 further comprises a top thick external conductive layer 60 and a bottom thick external conductive layer, 60' positioned at each side of the base structure 10. The top and bottom thick external conductive layers have a thickness greater than the thickness of the internal conductive layers 40, 40' of the base structure in order to enhance the current and thermal capabilities of the package structure. According to a non-limiting embodiment, the thick external conductive layers 60, 60' may have a thickness of about 100µm-4mm, preferably about 400 µm-1mm. Thus, a thick layer is a layer having a thickness greater than or equal to 100µm. The material of these layers is metal, preferably copper.

As shown in figure 1D, each external thick electrically conductive layer 60, 60' comprises plural pre-drilled through holes 61, 61' which are formed by mechanical process or other such as an electroerosion. These predrilled through holes 61, 61' are served as conductive vias holes for connecting the external thick conductive layers 60, 60' to the contact pads of the internal conductive layers 40, 40' as will be explained in more detail below.

By pre-drilled through holes it is understood that the holes are formed in the thick conductive layers prior to positioning the thick layers in the stack for forming the power assembly, e.g. prior to the step of lamination of the stack. Therefore, there is no limitation on the drilling technique. Thus and advantageously, the holes are formed by a mechanical drilling process in order to form deep holes. Typically, the pre-drilled through holes may have a hole diameter comprising between 100 µm and 1500 µm.

In an embodiment, these pre-drilled through holes 61, 61' are pre-filled with an insulating material by screen printing which will be removed later prior the step of electroplating process for forming conductive vias.

Moreover, the power assembly 100 further comprises a top internal insulating layer 50 and a bottom internal insulating layer 50', the top internal insulating layer 50 being disposed between the top external thick conductive layer 60 and the top internal thin electrically conductive layer 40 of the base structure 10 and the bottom internal insulating layer being 50' being disposed between the bottom external thick conductive layer 60' and the bottom internal conductive layer 40' of the base structure 10. For example, the internal insulating layers 50, 50' are made of resin or any appropriate insulating material with high thermal conductivity.

Referring to figure 1E, during the step of lamination of the stack which comprises the top and bottom insulating layers 50, 50', the top and bottom thick external electrically layers 60, 60' and the base structure 10, the epoxy resin present in the insulating layers 50, 50' flows and fill the pre-drilled through holes 61, 61' of the thick external conductive layers 60, 60'.

The insulating material in the pre-drilled through holes and underneath the pre-drilled through holes is then removed in order to form holes 62, 62' extending from the internal conductive layers 40, 40' to the external surface 65, 65' of the external thick conductive layers 60, 60', through the internal insulating layers 50, 50'.

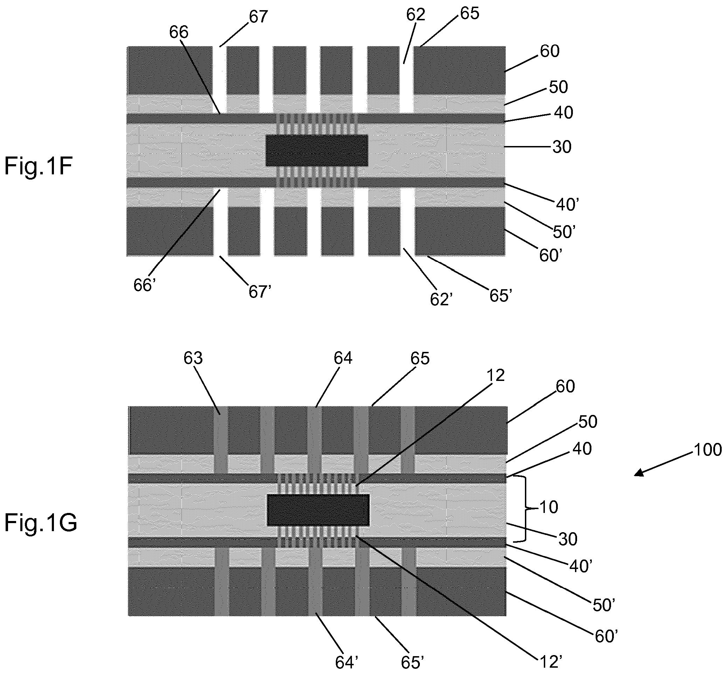

As shown in figure 1F, the electrical power assembly 100 also comprises a set of top holes 62 extending from the top internal conductive layer 40, through the top insulating layer 50 and the top thick external electrically layer 60 and a set of bottom holes 62' extending from the bottom internal conductive layer 40', through the bottom insulating layer 50' and the bottom thick external electrically layer 60'.

Each hole 62, 62' has a bottom 66, 66' and an open end 67, 67'. The bottom of the hole is formed by a portion of the contact pads of the internal conductive layers 40, 40' which are therefore exposed. The open end 67, 67' is formed at the surface 65, 65' of the external thick electrically conductive layer 60, 60'.

Each hole 62, 62' is formed in part by a hole formed in the internal insulating layers 50, 50' and in part by the pre-drilled through hole 61, 61' formed in the external thick conductive layers 60, 60'. The holes 62, 62' have a ratio vias hole depth to pre-drilled diameter ranging between 0.4 to 1.6, and preferably between 0.8 to 1.2.

Referring to figure 1G, the top and bottom holes 62, 62' are then filled with a conductive material 63 such as copper or a paste conductive material in order to form a set of top conductive vias 64 and a set of bottom conductive vias 64'. Preferably, the holes may be fully filled with the conductive material from the bottom of the holes until the surface of the external thick conductive layer.

According to another embodiment, the holes 62, 62' are plated by a conductive material. The assembly is dipped into two baths, the first being copper electroless plating in order to connect the internal conductive layers to the external conductive layers, a second being an electroplating bath in order to fully fill the holes 62, 62'.

Therefore the contact pads of the top internal conductive layer 40 are connected to the external thick conductive layer 60 by the top vias 64 arranged in the top internal insulating layer 50 and in the top external conductive layer 60. The contact pads of the bottom internal conductive layer 40' are connected to the bottom external thick conductive layer 60' by the bottom vias 64' arranged in the bottom internal insulating layer 50' and in the bottom external conductive layer 60'.

Consequently, the power device 20 is electrically connected with the top external thick conductive layer 60 and the bottom external thick conductive layer 60'.

Figure 2 is a schematic cross-sectional view illustrating an electrical power assembly 400 according to a second embodiment of the present invention. In comparison with the first embodiment shown in figure 1G, the electrical power assembly comprises plural power devices, for instance four power devices 421, 422, 423 and 424 as shown in figure 2. The power devices may same or different with each other. The number of the electrical contacts of each power device is determined according to the type of the power device. For example, as shown in figure 2, the power assembly comprises two diodes and two IGBT embedded in respective cavities of the electrically insulating core 430. The diode has two electrical contacts, namely an anode and a cathode, and the IGBT has three electrical contacts, an emitter, a gate and a collector.

The electrical contacts of the top side of each power device are connected to the top external thick conductive layer 460 through the top vias 412 formed in the electrically insulating core 430, the internal thin conductive layer 440, the external top vias 464 formed in the top internal insulating layer 450 and in the top external conductive layer 460. The electrical contacts of the bottom side of each power device are connected to the bottom external thick conductive layer 460' through the bottom vias 412' formed in the electrically insulating core 430, the bottom internal thin conductive layer 440', the external bottom vias 464' formed in the bottom internal insulating layer 450' and in the bottom external conductive layer 460'.

The power devices disposed in the power assembly are not limited to the configuration shown in figure 2 and can be varied according to the electronic function required for the power assembly.

Since the external conductive layers disposed on each side of the base structure have a thickness greater than 400 µm, the power transmission efficacy is largely enhanced. Moreover, since the holes of the external thick conductive layers which form the conductive vias are pre-drilled by mechanical process in the thick conductive layers, the manufacturing cost of the power assembly is reduced.

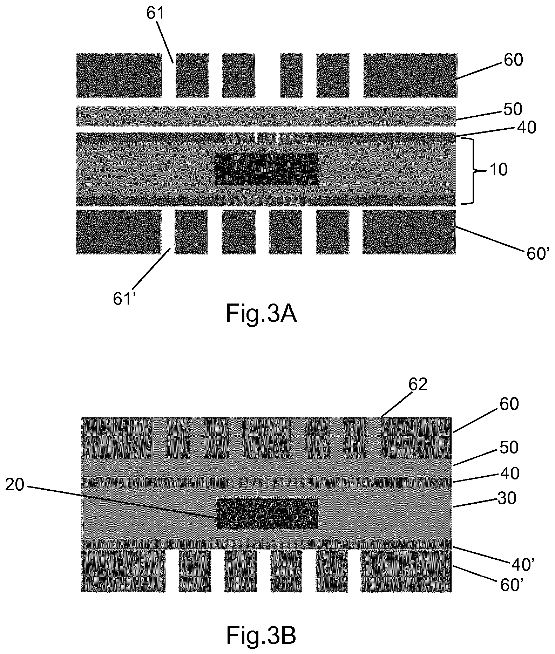

With reference to figures 3A to 3D, an electrical power assembly 200 according to a third embodiment of the present invention will be now described. In comparison with the embodiment shown in figures 1A-1G, there is no bottom electrically insulating layer between the bottom internal thin conductive layer 40' and the bottom external thick conductive layer 60'. In this embodiment, the bottom external thick conductive layer 60' is positioned directly on the bottom internal thin conductive layer 40'. Therefore, components parts and elements corresponding to those of the first embodiment are designated by identical numeral references, and details description therefore is omitted. Thus, the base structure of this embodiment is similar to the base structure of the first embodiment, and is not redundantly described below.

The power assembly 200 comprises a top thick external conductive layer 60 and a bottom thick external conductive layer, 60' positioned at each side of the base structure 10. The top and bottom thick external conductive layers have a thickness greater than the thickness of the internal conductive layers of the base structure in order to enhance the current and thermal capabilities of the package structure. According to a non-limiting embodiment, the thick external conductive layers 60, 60' may have a thickness of about 100µm-4mm, preferably about 400 µm-1mm. The material of these layers is metal, preferably copper.

As shown in figure 3A, each external thick electrically conductive layer 60, 60' comprises plural pre-drilled through holes 61, 61' which are formed by mechanical process or other appropriate technique. These predrilled through holes are served as conductive vias holes for connecting the external thick conductive layers 60, 60' to the contact pads of the internal conductive layers 40, 40' as will be explained in more details below.

Moreover, the power assembly 200 further comprises a top internal insulating layer 50 disposed between the top external thick conductive layer 60 and the top internal thin electrically conductive layer 40 of the base structure 10. For example, the internal insulating layer 50 is made of resin or any appropriate insulating material with high thermal conductivity.

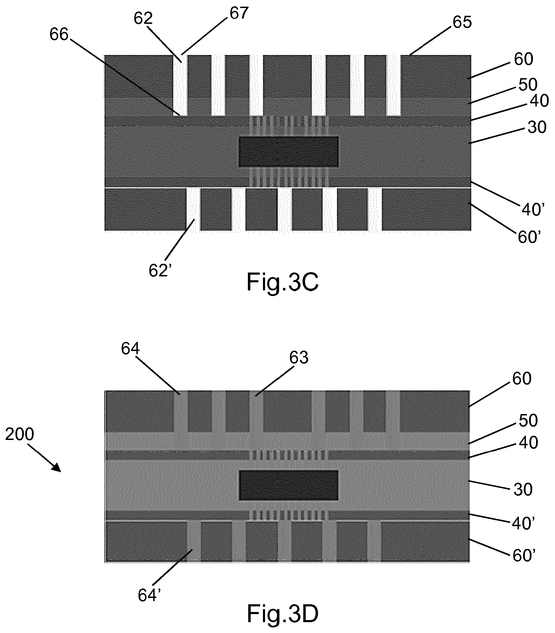

Referring to figure 3C, the electrical power assembly 200 comprises a set of top holes 62 extending from the top internal layer 40, through the top insulating layer 50 and the top thick external layer 60. Thus, each top hole 62 has a bottom 66 and an open end 67. The bottom of the hole is formed by a portion of the contact pads of the top internal conductive layer 40. The open end 67 is formed at the surface 65 of the top external thick electrically conductive layer 60. Each top hole 62 is formed in part by a hole formed in the top internal insulating layer 50 and in part by the predrilled through hole 61 formed in the top external thick conductive layers 60.

Referring to figure 3C, the electrical power assembly 200 comprises also a set of bottom holes 62' extending from the bottom internal electrical layer 40' to the bottom thick external electrically layer 60'. Thus, the bottom holes 62' are formed directly by the pre-drilled holes 61' formed in the bottom external thick conductive layer 60'.

The top and bottom holes 62, 62' are then filled by a conductive material in order to form the top conductive vias 64 and the bottom conductive vias 64'. Preferably, the holes 62, 62' may be fully filled with the conductive material from the bottom of the holes until the surface of the external thick conductive layer as shown in figure 3D. This step of filling allows making a mechanical adherence between the internal conductive layer 40, 40' and the respective thick conductive layers 60, 60'.

Therefore the contact pads of the top internal conductive layer 40 are connected to the top external thick conductive layer 60 by the top vias 64 arranged in the top internal insulating layer 50 and in the top external thick conductive layer 60. The contacts pads of the bottom internal conductive layer 40' are directly connected to the bottom external thick conductive layer 60' by the bottom vias 64'.

Furthermore, the top vias 64 and the bottom vias 64' provide a thermal path for heat dissipation of the power device.

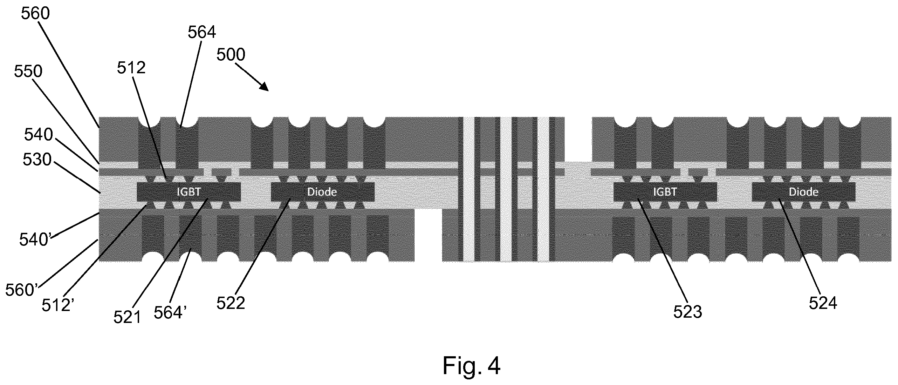

Figure 4 is a schematic cross-sectional view illustrating a power assembly 500 according to a fourth embodiment of the present invention. In comparison with the third embedment as shown in figure 3D, the power assembly of this embodiment comprises plural power devices, for instance four power devices 521, 521, 523, 524, two diodes and two IGBT. The configuration of the power devices is similar to the embodiment shown in figure 2.

The electrical contacts of the top side of each power device are connected to the top external thick conductive layer 560 through the top vias 512 formed in the electrically insulating core 530, the internal thin conductive layer 540, the external top vias 564 formed in the top internal insulating layer 550 and in the top external conductive layer 560. The electrical contacts of the bottom side of each power device are connected to the bottom external thick conductive layer 560' through the bottom vias 512' formed in the electrically insulating core 530, the bottom internal thin conductive layer 540', the external bottom vias 564' formed by the pre-drilled holes of the bottom external conductive layer 560'.

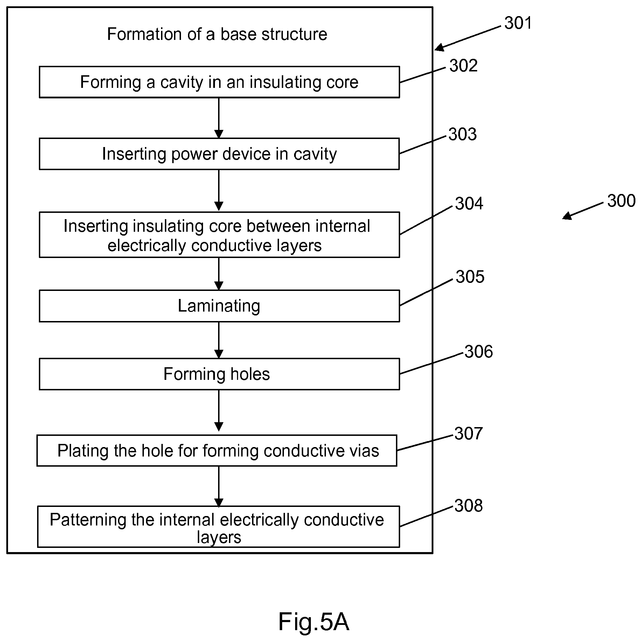

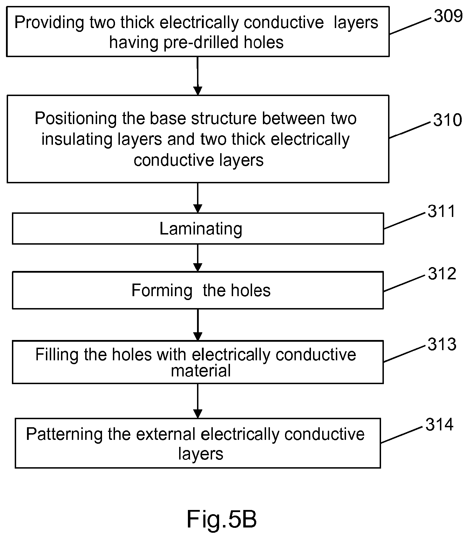

With reference to figure 5A and 5B, a manufacturing method 300 of an electrical power assembly as shown in figures 1A-1G according to an embodiment of the present invention will now be described. The method of forming the electrical assembly as shown in figures 2, 3 and 4 is similar and is not redundantly described.

The figure 5A illustrates an example of the formation 301 of the multilayer base structure 10.

At step 302, at least one cavity is formed in an insulating core. The cavity may be obtained for instance by mechanical drilling. The shape of the cavity is adapted to the power device.

At step 303, a power device 20 is inserted in the cavity. The power device may be a diode or a transistor such as a MOSFET, JFET or IGBT and can have the various configurations of electrical contacts. Moreover the number of the power devices can be also varied according to the electronic function requirements. Each power device is oriented in the cavity in a manner that the electrical contacts of the power device are facing upwardly and downwardly.

At step 304, the insulating core comprising the power device is positioned between two additional insulating layers and two thin internal conductive layers 40, 40', to obtain a stack.

At step 305, the stack of insulating layers and the conductive layers 40, 40' are laminated in order to form a solid multilayer structure, in which the insulating layers of the stack are fused together to form an insulating core 30 as shown in figure 1A. Thus, the power device 20 is embedded inside the insulating core 30.

The method then comprises a step 306 of forming a set of top holes 11 in the insulating core 30 and in the top internal conductive layer 40 and a set of bottom holes 11' in the insulating core 30 and in the bottom conductive layer 40'. The holes 11, 11'are formed by a laser drilling process in order to expose the electrical contacts of the power device.

At the step 307, the holes are plated with conductive material such as copper by an electroplating process in order to form conductive vias 12, 12'. The plating may be performed by electro less or/and electro plating. Preferably, the conductive material is copper. For example, the solid multilayer structure is dipped into two plating baths in order to fully fill the holes.

At the step 308, an etching step is applied on the surface of the top and bottom internal conductive layers 40, 40' in order to form the desired conductive patterns on both side of the base structure. These conductive patterns will be used as contacts pads.

At step 309, two thick conductive layers 60, 60' having pre-drilled through holes are provided. The thick conductive layers have a thickness of about 400 µm - 4 mm. In contrast with the conventional method, the external electrical conductive layers comprise pre-drilled through holes which have a diameter of about 500 µm - 1000 µm. As the holes are formed in the thick conductive layers prior to the step of the preparation of the stack, any appropriate drilling technique can be used. According to a preferred embodiment, the holes of the thick conductive layers are formed by a mechanical process.

At step 310, the base structure 10 is positioned between two additional internal electrically insulating layers 50, 50' and two thick external electrically conductive layers 60, 60' for forming a new stack.

According to another embodiment of the invention, at step 310, in the bottom part of the power assembly, the bottom external thick conductive layer 60' is positioned directly on the surface of the bottom internal thin conductive layer 40' as show in figure 3A.

At step 311, the stack comprising the base structure, the two additional internal electrically insulating layers and the two additional thick conductive layers is laminated in order to form a solid multilayer structure. The epoxy resin present in the insulating layers flows and fill the pre-drilled through holes 61, 61' of the thick external conductive layers 60, 60'.

In another embodiment, the pre-drilled through holes 61, 61' may be pre-filled with a paste insulating material during the step 308. The material may be epoxy, silicon or other any appropriate material that can be easily cleaned for the plating step.

At step 312, the insulating material in the pre-drilled through holes and underneath the pre-drilled through holes is removed in order to form holes 62, 62' extending from the internal conductive layers 40, 40' to the external surface 65, 65' of the external thick conductive layers 60, 60', through the internal insulating layers 50, 50'. Thus, each hole 62, 62' has a bottom 66, 66' formed by a portion of a contact pad of the internal conductive layers 40, 40' and an open end 67, 67' at the surface of the external thick conductive layers 60, 60'. This removing step can be performed by any appropriate process such as laser, chemical, mechanical, plasma process.

At step 313 and in reference to figure 1G, the holes 62, 62' are filled with conductive material 63 in order to form conductive vias 64, 64' to connect the contact pads of the internal conductive layers 40, 40' to the external thick conductive layers 60, 60'. For instance, the structure is dipped into two plating bath. The first is electroless plating in order to connect the internal thin conductive layers to the external thick conductive layers. The second bath is used to fully fill the holes with conductive material.

At step 314, the surface of the top thick conductive layer and the bottom thick conductive layer are patterned either by etching or milling. The conductive patterns may be served as contact pads for the power assembly. Consequently, several power assemblies may be inserted or integrated into another multilayer structure to form a power module.

Further, while not shown, the method may comprise further steps wherein the sequence of steps 309 to 313 is repeated at least once. Thus, the power assembly as shown in figures 1G, 2, 3D and 4 can be again positioned between two additional insulating layers and thick conductive layers comprising pred-drilled holes. In another embodiment, the sequence of steps 309 to 313 may be repeated a number of times necessary to obtain a desired total thickness for the external conductive layers on each side of the base structure. This thickness which is also required for increasing the power and thermal transmission may be in a range of between 1 mm and 100 mm.

## Claims

1. An electrical power assembly (100, 200, 400, 500), comprising:
- at least one multilayer base structure (10), at least one power device embedded (20, 421, 422, 423, 424, 521, 522, 523, 524) in the at least one multilayer base structure, an internal electrically conductive layer (40, 440, 540, 40', 440', 540') positioned on each side of the multilayer base structure, each internal electrically conductive layer comprising at least one contact pad connected to a respective electrical contact of the power device through connections (12, 12', 412, 412', 512, 512') arranged in the multilayer base structure;
- two external electrically conductive layers (60, 460, 560, 60', 460', 560') positioned on each side of the base structure (10), each external electrically conductive layer (60, 460, 560, 60', 460', 560') comprising at least one through hole (61, 61'), the at least one external electrically conductive layers being thicker than the internal conductive layers;
- at least one internal electrically insulating layer (50, 450, 550, 50', 450') positioned on at least one side of the base structure, said internal electrically insulating layer being positioned between the internal electrically conductive layer (40, 440, 540, 40', 440', 540') of the base structure (10) and a respective external electrically conductive layer (60, 460, 560, 60', 460', 560'),
- at least one hole (62, 62') extending from a contact pad of the internal electrically conductive layer (40, 440, 540, 40', 440', 540') to the external surface (65, 65') of the external electrically conductive layer in such that the hole has a bottom (66, 66') formed by a contact pad of the internal electrically conductive layer (40, 440, 540, 40', 440', 540'), a portion of each hole (62, 62') being formed by the through hole (61, 61') of the external electrically conductive layer,
- the at least one hole (62, 62') being filled with electrically conductive material (63) from the bottom of the hole to the external surface of the external electrically conductive layer in order to form external conductive vias (64, 464, 564, 64', 464', 564') to connect the contact pad of the internal electrically conductive layer (40, 440, 540, 40', 440', 540') to the respective external electrically conductive layer (60, 460, 560, 60', 460', 560').

2. The electrically power assembly (100, 200, 400, 500) according to claim 1, wherein said at least one multilayer base structure (10) comprises:
- an electrically insulating core (30, 430, 530),
- at least one power device (20, 421, 422, 423, 424, 521, 522, 523, 524) embedded in the electrically insulating core (30, 430, 530), each power device having opposite electrical contacts,
- two internal electrically conductive layers (40, 440, 540, 40', 440', 540') on opposite surfaces of the electrically insulating core (30, 430, 530),
- each internal electrically conductive layers (40, 440, 540, 40', 440', 540') comprising at least one contact pad connected to a respective electrical contact of the power device (20) through connections (12, 412, 512, 12', 412', 512') arranged in the electrically insulating core (30, 430, 530) and in the internal conductive layers (40, 440, 540, 40', 440', 540').

3. The electrical power assembly according to claim 1 or 2, wherein the thickness of the external layers is in a range of between 100 µm to 4 mm, and preferably 400 µm to 1 mm.

4. The electrical power assembly according to any one of claims 1 to 3, wherein the at least one hole (62, 62') have a ratio hole depth to diameter of the holes of the external electrically conductive layer, in range of between 0.4 to 1.6, and preferably 0.8 to 1.2.

5. The electrical power assembly according to any one of claims 1 to 4, wherein the connections (12, 412, 512, 12', 412', 512') between an internal electrically conductive layer (40, 440, 540, 40', 440', 540') and an electrical contact of a power device (20) are conductive vias.

6. The electrical power assembly according to any one of claims 1 to 5, wherein the diameter of the at least one hole (62, 62') is in a range of between 100µm to 1500µm.

7. The electrical power assembly according to any one of claims 1 to 6, wherein the at least one power device is a diode, a transistor such as a MOSFET, **JFET** or IGBT.

8. A method (300) for manufacturing an electrical power assembly (100, 200, 400, 500) according to any one of claims 1 to 7, comprising:
a) forming (301) a multilayer base structure (10), at least one power device embedded in the multilayer base structure, an internal electrically conductive layer (40, 440, 540, 40', 440', 540') positioned on each side of the at least one base structure, each internal electrically conductive layer comprising at least one contact pad connected to a respective electrical contact of the power device through connections arranged in the multilayer base structure;
b) providing (309) two external electrically conductive layers (60, 460, 560, 60', 460', 560'), the external electrically conductive layers having at least one pre-drilled through hole (61, 61'), the external electrically conductive layers being thicker than the internal conductive layers;
c) positioning (310) an external electrically conductive layer on each side of the base structure and positioning at least one internal electrically insulating layer (50, 450, 550, 50', 450') between the internal electrically conductive layer of the base structure and the external electrically conductive layer on at least one side of the base structure;
d) laminating (311) the base structure (10), the internal electrically insulating layers (50, 450, 550, 50', 450') and the external electrically conductive layers (60, 460, 560, 60', 460', 560');
e) forming (312) at least one hole (62, 62') by removing a stack comprising a portion of the internal electrically insulating layer (50, 50') and a portion of the material filling the at least one through hole (61, 61'), such that the at least one hole has a bottom formed by a contact pad of the internal electrically conductive layer;
f) filling (313) the at least one hole (62, 62') with electrically conductive material in order to form the external conductive vias (64, 464, 564, 64', 464', 564') to connect the contact pad of the internal electrically conductive layer of the multilayer base structure (10) to the external electrically conductive layer
g) patterning (314) the surface layers of external electrically conductive layers in order to form conductive patterns.

9. The method (300) for manufacturing an electrical power assembly (100, 200, 400, 500) according to claim 8, wherein the step (301) of forming the multilayer base structure comprises:
- forming (302) at least one cavity in an electrically insulating core (30, 430, 530),
- inserting (303) at least one power device (20, 421, 422, 423, 424, 521, 522, 523, 524) in each cavity,
- positioning (304) two internal electrically conductive layers (40, 440, 540, 40', 440', 540') on opposite surfaces of the electrically insulating core,
- laminating (305) the electrically insulating core and the internal electrically conductive layers (40, 440, 540, 40', 440', 540'),
- forming (306) holes in the electrically insulating core and in the internal electrically conductive layers,
- plating (307) the holes in order to connect the at least one contact pad of the internal electrically conductive layers to a respective electrical contact of the power device (20, 421, 422, 423, 424, 521, 522, 523, 524),
- patterning (308) the surface layers of internal electrically conductive layers (40, 440, 540, 40', 440', 540') in order to form conductive patterns.

10. The method (300) for manufacturing an electrical power assembly according to claim 8 or 9, wherein the sequence of steps (b) to (g) is repeated at least once.

11. The method (300) for manufacturing an electrical power assembly according to claim 10 10, wherein the sequence of steps (b) to (g) is repeated a number of times necessary to obtain a desired total thickness for the external conductive layers on each side of the base structure comprising between 1 mm and 100 mm.

12. The method (300) for manufacturing an electrical power assembly according to any one of claims 8 to 11, wherein each external electrically conductive layer (60, 60') have a thickness in a range of between 100 µm to 4 mm, and preferably 400 µm to 1 mm.

13. The method (300) for manufacturing an electrical power assembly according to any one of claims 8 to 12, wherein the at least one through hole (61, 61') of the external electrically conductive layers is pre-filled with a paste insulating material before positioning the external electrically conductive layers on each side of the base structure.

14. The method for manufacturing an electrical power assembly according to claim 13, wherein said paste insulating material is choosing among the group consisting of: epoxy resin, silicon.

15. The method for manufacturing an electrical power assembly according to any one of claims 8 to 14, wherein the at least one hole (62, 62') have a ratio vias hole depth to hole diameter of the holes of the external electrically conductive layer ranging between 0.4 to 1.6, and preferably between 0.8 to 1.2.

## Patentansprüche

1. Elektrische Leistungsbaugruppe (100, 200, 400, 500), umfassend:
- wenigstens eine mehrschichtige Basisstruktur (10), wenigstens ein Leistungsbauelement (20, 421, 422, 423, 424, 521, 522, 523, 524), welches in der wenigstens einen mehrschichtigen Basisstruktur eingebettet ist, eine innere elektrisch leitfähige Schicht (40, 440, 540, 40', 440', 540'), welche an jeder Seite der mehrschichtigen Basisstruktur positioniert ist, wobei jede innere elektrisch leitfähige Schicht wenigstens einen Kontaktpad aufweist, welcher mit einem entsprechenden elektrischen Kontakt des Leistungsbauelements durch Verbindungen (12, 12', 412, 412', 512, 512') verbunden ist, welche in der mehrschichtigen Basisstruktur angeordnet sind;
- zwei äußere elektrisch leitfähige Schichten (60, 460, 560, 60', 460', 560'), welche an jeder Seite der Basisstruktur (10) positioniert sind, wobei jede äußere elektrisch leitfähige Schicht (60, 460, 560, 60', 460', 560') wenigstens ein Durchgangsloch (61, 61') umfasst, wobei die wenigstens eine äußere elektrisch leitfähige Schicht dicker ist als die inneren leitfähigen Schichten;
- wenigstens eine innere elektrisch isolierende Schicht (50, 450, 550, 50', 450'), welche an wenigstens einer Seite der Basisstruktur positioniert ist, wobei die innere elektrisch isolierende Schicht zwischen der inneren elektrisch leitfähigen Schicht (40, 440, 540, 40', 440', 540') der Basisstruktur (10) und einer entsprechenden äußeren elektrisch leitfähigen Schicht (60, 460, 560, 60', 460', 560') positioniert ist,
- wenigstens ein Loch (62, 62'), welches sich von einem Kontaktpad der inneren elektrisch leitfähigen Schicht (40, 440, 540, 40', 440', 540') bis zur äußeren Oberfläche (65, 65') der äußeren elektrisch leitfähigen Schicht erstreckt, derart, dass das Loch einen Boden (66, 66') aufweist, welcher durch einen Kontaktpad der inneren elektrisch leitfähigen Schicht (40, 440, 540, 40', 440', 540') gebildet ist, wobei ein Abschnitt jedes Lochs (62, 62') durch das Durchgangsloch (61, 61') der äußeren elektrisch leitfähigen Schicht gebildet ist,
- wobei das wenigstens eine Loch (62, 62') mit elektrisch leitfähigem Material (63) von dem Boden des Lochs bis zur äußeren Oberfläche der äußeren elektrisch leitfähigen Schicht gefüllt ist, um äußere leitfähige Durchkontaktierungen (64, 464, 564, 64', 464', 564') auszubilden, um den Kontaktpad der inneren elektrisch leitfähigen Schicht (40, 440, 540, 40', 440', 540') mit der entsprechenden äußeren elektrisch leitfähigen Schicht (60, 460, 560, 60', 460', 560') zu verbinden.

2. Elektrische Leistungsbaugruppe (100, 200, 400, 500) nach Anspruch 1, wobei die wenigstens eine mehrschichtige Basisstruktur (10) umfasst:
- einen elektrisch isolierenden Kern (30, 430, 530),
- wenigstens ein Leistungsbauelement (20, 421, 422, 423, 424, 521, 522, 523, 524), welches in dem elektrisch isolierenden Kern (30, 430, 530) eingebettet ist, wobei jedes Leistungsbauelement gegenüberliegende elektrische Kontakte aufweist,
- zwei innere elektrisch leitfähige Schichten (40, 440, 540, 40', 440', 540') an gegenüberliegenden Oberflächen des elektrisch isolierenden Kerns (30, 430, 530),
- wobei jede innere elektrisch leitfähige Schicht (40, 440, 540, 40', 440', 540') wenigstens einen Kontaktpad umfasst, welcher mit einem entsprechenden elektrischen Kontakt des Leistungsbauelements (20) durch Verbindungen (12, 412, 512, 12', 412', 512') verbunden ist, welche in dem elektrisch isolierenden Kern (30, 430, 530) und in den inneren leitfähigen Schichten (40, 440, 540, 40', 440', 540') angeordnet sind.

3. Elektrische Leistungsbaugruppe nach Anspruch 1 oder 2, wobei die Dicke der äußeren Schichten in einem Bereich von 100 µm bis 4 mm, und vorzugsweise 400 µm bis 1 mm liegt.

4. Elektrische Leistungsbaugruppe nach einem der Ansprüche 1 bis 3, wobei das wenigstens eine Loch (62, 62') ein Verhältnis von Lochtiefe zu Durchmesser der Löcher der äußeren elektrisch leitfähigen Schicht in einem Bereich von 0,4 bis 1,6, und vorzugsweise 0,8 bis 1,2 aufweist.

5. Elektrische Leistungsbaugruppe nach einem der Ansprüche 1 bis 4, wobei die Verbindungen (12, 412, 512, 12', 412', 512') zwischen einer inneren elektrisch leitfähigen Schicht (40, 440, 540, 40', 440', 540') und einem elektrischen Kontakt eines Leistungsbauelements (20) leitfähige Durchkontaktierungen sind.

6. Elektrische Leistungsbaugruppe nach einem der Ansprüche 1 bis 5, wobei der Durchmesser des wenigstens einen Lochs (62, 62') in einem Bereich von 100 µm bis 1500 µm liegt.

7. Elektrische Leistungsbaugruppe nach einem der Ansprüche 1 bis 6, wobei das wenigstens eine Leistungsbauelement eine Diode, ein Transistor wie ein MOSFET, JFET oder IGBT ist.

8. Verfahren (300) zur Herstellung einer elektrischen Leistungsbaugruppe (100, 200, 400, 500) nach einem der Ansprüche 1 bis 7, umfassend:
a) Ausbilden (301) einer mehrschichtigen Basisstruktur (10), wobei wenigstens ein Leistungsbauelement in der mehrschichtigen Basisstruktur eingebettet wird, wobei eine innere elektrisch leitfähige Schicht (40, 440, 540, 40', 440', 540') an jeder Seite der wenigstens einen Basisstruktur positioniert wird, wobei jede innere elektrisch leitfähige Schicht wenigstens einen Kontaktpad aufweist, welcher mit einem entsprechenden elektrischen Kontakt des Leistungsbauelements durch Verbindungen verbunden ist, welche in der mehrschichtigen Basisstruktur angeordnet werden;
b) Bereitstellen (309) zweier äußerer elektrisch leitfähiger Schichten (60, 460, 560, 60', 460', 560'), wobei die äußeren elektrisch leitfähigen Schichten wenigstens ein vorgebohrtes Durchgangsloch (61, 61') aufweisen, wobei die äußeren elektrisch leitfähigen Schichten dicker sind als die inneren leitfähigen Schichten;
c) Positionieren (310) einer äußeren elektrisch leitfähigen Schicht an jeder Seite der Basisstruktur und Positionieren wenigstens einer inneren elektrisch isolierenden Schicht (50, 450, 550, 50', 450') zwischen der inneren elektrisch leitfähigen Schicht der Basisstruktur und der äußeren elektrisch leitfähigen Schicht an wenigstens einer Seite der Basisstruktur;
d) Laminieren (311) der Basisstruktur (10), der inneren elektrisch isolierenden Schichten (50, 450, 550, 50', 450') und der äußeren elektrisch leitfähigen Schichten (60, 460, 560, 60', 460', 560');
e) Ausbilden (312) wenigstens eines Lochs (62, 62') durch Entfernen eines Stapels, welcher einen Abschnitt der inneren elektrisch isolierenden Schicht (50, 50') und einen Abschnitt des Materials umfasst, welches das wenigstens eine Durchgangsloch (61, 61') füllt, derart, dass das wenigstens eine Loch einen Boden aufweist, welcher durch einen Kontaktpad der inneren elektrisch leitfähigen Schicht gebildet wird;
f) Füllen (313) des wenigstens einen Lochs (62, 62') mit elektrisch leitfähigem Material, um die äußeren leitfähigen Durchkontaktierungen (64, 464, 564, 64', 464', 564') auszubilden, um den Kontaktpad der inneren elektrisch leitfähigen Schicht der mehrschichtigen Basisstruktur (10) mit der äußeren elektrisch leitfähigen Schicht zu verbinden;
g) Strukturieren (314) der Oberflächenschichten von äußeren elektrisch leitfähigen Schichten, um leitfähige Strukturen auszubilden.

9. Verfahren (300) zur Herstellung einer elektrischen Leistungsbaugruppe (100, 200, 400, 500) nach Anspruch 8, wobei der Schritt (301) des Ausbildens der mehrschichtigen Basisstruktur umfasst:
- Ausbilden (302) wenigstens einer Kavität in einem elektrisch isolierenden Kern (30, 430, 530),
- Einsetzen (303) wenigstens eines Leistungsbauelements (20, 421, 422, 423, 424, 521, 522, 523, 524) in jede Kavität,
- Positionieren (304) zweier innerer elektrisch leitfähiger Schichten (40, 440, 540, 40', 440', 540') an gegenüberliegenden Oberflächen des elektrisch isolierenden Kerns,
- Laminieren (305) des elektrisch isolierenden Kerns und der inneren elektrisch leitfähigen Schichten (40, 440, 540, 40', 440', 540'),
- Ausbilden (306) von Löchern in dem elektrisch isolierenden Kern und in den inneren elektrisch leitfähigen Schichten,
- Beschichten (307) der Löcher, um den wenigstens einen Kontaktpad der inneren elektrisch leitfähigen Schichten mit einem entsprechenden elektrischen Kontakt des Leistungsbauelements (20, 421, 422, 423, 424, 521, 522, 523, 524) zu verbinden,
- Strukturieren (308) der Oberflächenschichten von inneren elektrisch leitfähigen Schichten (40, 440, 540, 40', 440', 540'), um leitfähige Strukturen auszubilden.

10. Verfahren (300) zur Herstellung einer elektrischen Leistungsbaugruppe nach Anspruch 8 oder 9, wobei die Abfolge der Schritte (b) bis (g) wenigstens einmal wiederholt wird.

11. Verfahren (300) zur Herstellung einer elektrischen Leistungsbaugruppe nach Anspruch 10, wobei die Abfolge der Schritte (b) bis (g) so oft wiederholt wird, wie es erforderlich ist, um eine gewünschte Gesamtdicke für die äußeren leitfähigen Schichten an jeder Seite der Basisstruktur zu erhalten, welche zwischen 1 mm und 100 mm umfasst.

12. Verfahren (300) zur Herstellung einer elektrischen Leistungsbaugruppe nach einem der Ansprüche 8 bis 11, wobei jede äußere elektrisch leitfähige Schicht (60, 60') eine Dicke in einem Bereich von 100 µm bis 4 mm, und vorzugsweise 400 µm bis 1 mm aufweist.

13. Verfahren (300) zur Herstellung einer elektrischen Leistungsbaugruppe nach einem der Ansprüche 8 bis 12, wobei das wenigstens eine Durchgangsloch (61, 61') der äußeren elektrisch leitfähigen Schichten mit einem pastösen Isoliermaterial vorgefüllt wird, bevor die äußeren elektrisch leitfähigen Schichten an jeder Seite der Basisstruktur positioniert werden.

14. Verfahren zur Herstellung einer elektrischen Leistungsbaugruppe nach Anspruch 13, wobei das pastöse Isoliermaterial aus der Gruppe ausgewählt wird, welche besteht aus: Epoxidharz, Silikon.

15. Verfahren zur Herstellung einer elektrischen Leistungsbaugruppe nach einem der Ansprüche 8 bis 14, wobei das wenigstens eine Loch (62, 62') ein Verhältnis von Durchkontaktierungslochtiefe zu Lochdurchmesser der Löcher der äußeren elektrisch leitfähigen Schicht aufweist, welches zwischen 0,4 und 1,6, und vorzugsweise zwischen 0,8 und 1,2 liegt.

## Revendications

1. Ensemble d'alimentation électrique (100, 200, 400, 500), comprenant :
- au moins une structure de base (10) multicouche, au moins un dispositif d'alimentation (20, 421, 422, 423, 424, 521, 522, 523, 524) intégré dans l'au moins une structure de base multicouche, une couche électriquement conductrice interne (40, 440, 540, 40', 440', 540') positionnée sur chaque côté de la structure de base multicouche, chaque couche électriquement conductrice interne comprenant au moins un plot de contact connecté à un contact électrique respectif du dispositif d'alimentation par l'intermédiaire de connexions (12, 12', 412, 412', 512, 512') agencées dans la structure de base multicouche ;
- deux couches électriquement conductrices externes (60, 460, 560, 60', 460', 560') positionnées sur chaque côté de la structure de base (10), chaque couche électriquement conductrice externe (60, 460, 560, 60', 460', 560') comprenant au moins un trou traversant (61, 61'), l'au moins une couche électriquement conductrice externe étant plus épaisse que les couches conductrices internes ;
- au moins une couche électriquement isolante interne (50, 450, 550, 50', 450') positionnée sur au moins un côté de la structure de base, ladite couche électriquement isolante interne étant positionnée entre la couche électriquement conductrice interne (40, 440, 540, 40', 440', 540') de la structure de base (10) et une couche électriquement conductrice externe (60, 460, 560, 60', 460', 560') respective,
- au moins un trou (62, 62') s'étendant à partir d'un plot de contact de la couche électriquement conductrice interne (40, 440, 540, 40', 440', 540') jusqu'à la surface externe (65, 65') de la couche électriquement conductrice externe de telle sorte que le trou ait un fond (66, 66') formé par un plot de contact de la couche électriquement conductrice interne (40, 440, 540, 40', 440', 540'), une partie de chaque trou (62, 62') étant formée par le trou traversant (61, 61') de la couche électriquement conductrice externe,
- l'au moins un trou (62, 62') étant rempli d'un matériau électriquement conducteur (63) depuis le fond du trou jusqu'à la surface externe de la couche électriquement conductrice externe afin de former des trous d'interconnexion conducteurs externes (64, 464, 564, 64', 464', 564') pour connecter le plot de contact de la couche électriquement conductrice interne (40, 440, 540, 40', 440', 540') à la couche électriquement conductrice externe (60, 460, 560, 60', 460', 560') respective.

2. Ensemble d'alimentation électrique (100, 200, 400, 500) selon la revendication 1, dans lequel ladite au moins une structure de base multicouche (10) comprend :
- un noyau électriquement isolant (30, 430, 530),
- au moins un dispositif d'alimentation (20, 421, 422, 423, 424, 521, 522, 523, 524) intégré dans le noyau électriquement isolant (30, 430, 530), chaque dispositif d'alimentation ayant des contacts électriques opposés,
- deux couches électriquement conductrices internes (40, 440, 540, 40', 440', 540') sur des surfaces opposées du noyau électriquement isolant (30, 430, 530),
- chaque couche électriquement conductrice interne (40, 440, 540, 40', 440', 540') comprenant au moins un plot de contact connecté à un contact électrique respectif du dispositif d'alimentation (20) par l'intermédiaire de connexions (12, 412, 512, 12', 412', 512') agencées dans le noyau électriquement isolant (30, 430, 530) et dans les couches conductrices internes (40, 440, 540, 40', 440', 540').

3. Ensemble d'alimentation électrique selon la revendication 1 ou 2, dans lequel l'épaisseur des couches externes est dans une plage de 100 µm à 4 mm, et de préférence de 400 µm à 1 mm.

4. Ensemble d'alimentation électrique selon l'une quelconque des revendications 1 à 3, dans lequel l'au moins un trou (62, 62') a un rapport de profondeur de trou à diamètre des trous de la couche électriquement conductrice externe, dans une plage de 0,4 à 1,6, et de préférence de 0,8 à 1,2.

5. Ensemble d'alimentation électrique selon l'une quelconque des revendications 1 à 4, dans lequel les connexions (12, 412, 512, 12', 412', 512') entre une couche électriquement conductrice interne (40, 440, 540, 40', 440', 540') et un contact électrique d'un dispositif d'alimentation (20) sont des trous d'interconnexion conducteurs.

6. Ensemble d'alimentation électrique selon l'une quelconque des revendications 1 à 5, dans lequel le diamètre de l'au moins un trou (62, 62') est dans une plage de 100 µm à 1 500 µm.

7. Ensemble d'alimentation électrique selon l'une quelconque des revendications 1 à 6, dans lequel l'au moins un dispositif d'alimentation est une diode, un transistor tel qu'un MOSFET, un JFET ou un IGBT.

8. Procédé (300) de fabrication d'un ensemble d'alimentation électrique (100, 200, 400, 500) selon l'une quelconque des revendications 1 à 7, comprenant :
a) la formation (301) d'une structure de base multicouche (10), d'au moins un dispositif d'alimentation intégré dans la structure de base multicouche, d'une couche électriquement conductrice interne (40, 440, 540, 40', 440', 540') positionnée sur chaque côté de l'au moins une structure de base, chaque couche électriquement conductrice interne comprenant au moins un plot de contact connecté à un contact électrique respectif du dispositif d'alimentation par l'intermédiaire de connexions agencées dans la structure de base multicouche ;
b) la fourniture (309) de deux couches électriquement conductrices externes (60, 460, 560, 60', 460', 560'), les couches électriquement conductrices externes ayant au moins un trou traversant (61, 61') prépercé, les couches électriquement conductrices externes étant plus épaisses que les couches conductrices internes ;
c) le positionnement (310) d'une couche électriquement conductrice externe sur chaque côté de la structure de base et le positionnement d'au moins une couche électriquement isolante interne (50, 450, 550, 50', 450') entre la couche électriquement conductrice interne de la structure de base et la couche électriquement conductrice externe sur au moins un côté de la structure de base ;
d) la stratification (311) de la structure de base (10), des couches électriquement isolantes internes (50, 450, 550, 50', 450') et des couches électriquement conductrices externes (60, 460, 560, 60', 460', 560') ;
e) la formation (312) d'au moins un trou (62, 62') en retirant un empilement comprenant une partie de la couche électriquement isolante interne (50, 50') et une partie du matériau remplissant l'au moins un trou traversant (61, 61'), de telle sorte que l'au moins un trou ait un fond formé par un plot de contact de la couche électriquement conductrice interne ;
f) le remplissage (313) de l'au moins un trou (62, 62') de matériau électriquement conducteur afin de former les trous d'interconnexion conducteurs externes (64, 464, 564, 64', 464', 564') pour connecter le plot de contact de la couche électriquement conductrice interne de la structure de base multicouche (10) à la couche électriquement conductrice externe ;
g) la formation de motifs (314) sur les couches de surface de couches électriquement conductrices externes afin de former des motifs conducteurs.

9. Procédé (300) de fabrication d'un ensemble d'alimentation électrique (100, 200, 400, 500) selon la revendication 8, dans lequel l'étape (301) de formation de la structure de base multicouche comprend :
- la formation (302) d'au moins une cavité dans un noyau électriquement isolant (30, 430, 530),
- l'insertion (303) d'au moins un dispositif d'alimentation (20, 421, 422, 423, 424, 521, 522, 523, 524) dans chaque cavité,
- le positionnement (304) de deux couches électriquement conductrices internes (40, 440, 540, 40', 440', 540') sur des surfaces opposées du noyau électriquement isolant,
- la stratification (305) du noyau électriquement isolant et des couches électriquement conductrices internes (40, 440, 540, 40', 440', 540'),
- la formation (306) de trous dans le noyau électriquement isolant et dans les couches électriquement conductrices internes,
- le placage (307) des trous afin de connecter l'au moins un plot de contact des couches électriquement conductrices internes à un contact électrique respectif du dispositif d'alimentation (20, 421, 422, 423, 424, 521, 522, 523, 524),
- la formation de motifs (308) sur les couches de surface de couches électriquement conductrices internes (40, 440, 540, 40', 440', 540') afin de former des motifs conducteurs.

10. Procédé (300) de fabrication d'un ensemble d'alimentation électrique selon la revendication 8 ou 9, dans lequel la séquence des étapes (b) à (g) est répétée au moins une fois.

11. Procédé (300) de fabrication d'un ensemble d'alimentation électrique selon la revendication 10, dans lequel la séquence des étapes (b) à (g) est répétée un nombre de fois nécessaire pour obtenir une épaisseur totale souhaitée pour les couches conductrices externes sur chaque côté de la structure de base comprenant entre 1 mm et 100 mm.

12. Procédé (300) de fabrication d'un ensemble d'alimentation électrique selon l'une quelconque des revendications 8 à 11, dans lequel chaque couche électriquement conductrice externe (60, 60') a une épaisseur dans une plage de 100 µm à 4 mm, et de préférence de 400 µm à 1 mm.

13. Procédé (300) de fabrication d'un ensemble d'alimentation électrique selon l'une quelconque des revendications 8 à 12, dans lequel l'au moins un trou traversant (61, 61') des couches électriquement conductrices externes est prérempli d'un matériau isolant en pâte avant de positionner les couches électriquement conductrices externes sur chaque côté de la structure de base.

14. Procédé de fabrication d'un ensemble d'alimentation électrique selon la revendication 13, dans lequel ledit matériau isolant en pâte est choisi dans le groupe constitué de : résine époxy, silicium.

15. Procédé de fabrication d'un ensemble d'alimentation électrique selon l'une quelconque des revendications 8 à 14, dans lequel l'au moins un trou (62, 62') a un rapport de profondeur de trou de trous d'interconnexion à diamètre de trou des trous de la couche électriquement conductrice externe de 0,4 à 1,6, et de préférence de 0,8 à 1,2.
